# EUROPÄISCHE PATENTANMELDUNG

(11) **EP 2 525 414 A2**
(43) Veröffentlichungstag der Anmeldung: **21.11.2012**
(21) Anmeldenummer: 12167838.7
(22) Anmeldetag: 14.05.2012
(51) Int. Cl.: H01L 31/048

(54) **Glasloses Photovoltaik-Modul und Verfahren zu seiner Herstellung**

(30) Priorität: 14.05.2011 DE 102011101908
(71) Anmelder: Kalberlah, Klaus, 14947 Nuthe-Urstromtal (DE)
(72) Erfinder: Kalberlah, Klaus Dr., 14947 Nuthe-Urstromtal (DE); Frost, Andreas, 16341 Panketal (DE)
(74) Vertreter: Gulde Hengelhaupt Ziebig & Schneider

(57) **Zusammenfassung**

Die Erfindung betrifft ein Verfahren zur Herstellung eines glaslosen Photovoltaik-Modul mit einer elektrischen Reihenschaltung mehrerer photovoltaischer Solarzellen, die verkapselt zwischen einer Kunststoffschicht aus einem transparenten, thermoplastischen Kunststoff und einem rückseitigen Trägersubstrat angeordnet sind. Das Verfahren zeichnet sich dadurch aus, dass die Kunststoffschicht durch Extrusion des thermoplastischen Kunststoffs auf einen Rohling des Photovoltaik-Moduls aufgetragen wird. Die Erfindung betrifft weiterhin ein entsprechendes glasloses Photovoltaik-Modul.

## Beschreibung

Die Erfindung betrifft ein Verfahren zur Herstellung eines glaslosen Photovoltaik-Modul sowie ein über das Verfahren erhältliches glasloses Photovoltaik-Modul.

### Stand der Technik und Hintergrund der Erfindung

Die vorliegende Erfindung befasst sich mit der glaslosen Lamination von Photovoltaik-Modulen (PV-Modulen) in einem kostengünstigen, kontinuierlichen Massen-Produktionsverfahren. Insbesondere betrifft die Erfindung sowohl glaslose PV-Module mit kristallinen Siliziumzellen als auch Dünnschicht-Solarzellen. Dies geschieht vor dem Hintergrund eines gravierenden Preisverfalls bei konventionellen PV-Modulen, was einerseits zur Notwendigkeit von Kosteneinsparungen bei der Modulherstellung und andererseits zu dem Wunsch zur Nutzung von Alleinstellungsmerkmalen gegenüber Standardprodukten führt, z. B. Alleinstellung durch geringes Gewicht, glaslose Bauweise, ggf. auch Flexibilität. Dabei wird das Kostenreduktionspotential bei der Herstellung der eigentlichen Solarzellen als weitgehend ausgeschöpft angesehen bzw. ist nicht Gegenstand des vorliegenden Schutzbegehrens, vielmehr geht es hier um sogenanntes "packaging", d. h. die nicht photoaktiven Schichten/Komponenten eines PV-Moduls.

Weltweit werden, mit 35 % jährlicher Zuwachsrate, in 2012 voraussichtlich 19 GWp = 190 Millionen Quadratmeter PV-Module hergestellt, wobei die Verkapselung/Lamination der Solarzellen in aller Regel wie folgt abläuft:

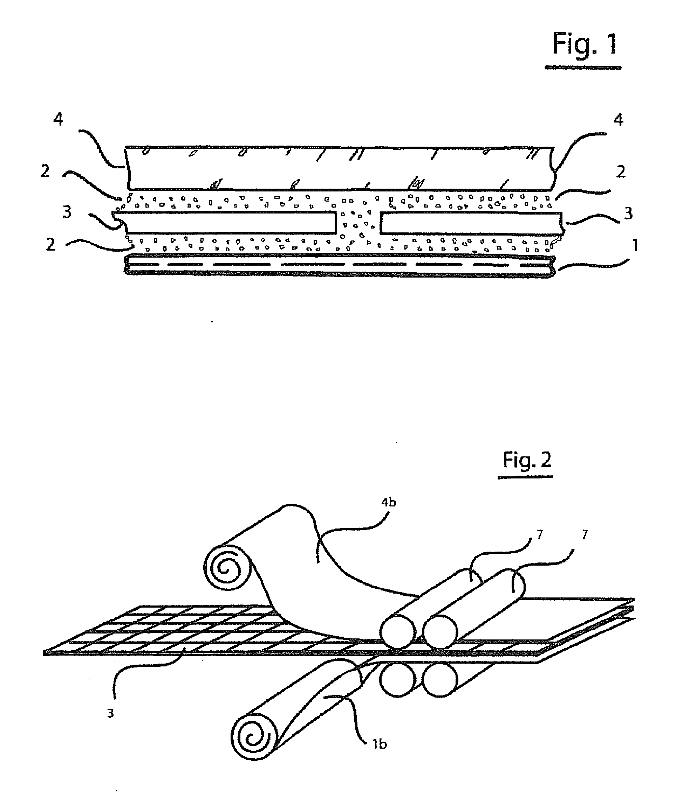

Figur 1 zeigt ein durch konventionelle EVA/ETFE-Lamination erhaltenes PV-Modul. Die elektrisch in Reihe geschalteten Solarzellen 3 werden beiderseits mit einer EVA - (Ethylenvinylacetat) Schmelzklebefolie 2 sowie vorderseitig mit einer Glasscheibe 4 und rückseitig mit einer lichtundurchlässigen Sperrfolie 1 abgedeckt; dieses "Sandwich" wird ca. 15 min bei ca. 130°C unter Atmosphären-Druck und unter Evakuierung der Luft in einem Flachbett-Laminator "verbacken" (EVA ist ein Duromer). Der PV-Modul wird hierdurch alterungsbeständig verkapselt, d. h. die Dichtigkeit der "Verpackung" ist ausreichend, eine 20 jährige Garantie auf die elektrische Leistung des Moduls zu geben.

Die Nachteile dieser derzeitigen Vorgehensweise sind:
a) Wegen der Verwendung von Silikatglas (thermisch gehärtetes Sicherheitsglas benötigt mindestens 2,7mm Dicke) hat das Modul ein erhebliches Gewicht. Es besteht Bruchgefahr und eine Flexibilität des Moduls ist naturgemäß nicht gegeben.
b) Die verwendeten Materialien (EVA-Schmelzklebefolie) sind teurer als Kunststoffglas.
c) Die Anlagenkosten für Flachbett-Laminatoren sind beträchtlich, insbesondere für sehr lange Laminate zur Dachverklebung (6m Länge oder mehr).
d) Vor allem aber handelt es sich bei der konventionellen Lamination um einen batch-Prozess mit hohem Zeitbedarf, und somit um einen wenig kostengünstigen Schritt im Massenherstellungsprozess von PV- Modulen.

Die genannten Nachteile gelten gleichermaßen für Standard-PV-Module, d. h. für die konventionelle Verkapselung von kristallinen Siliziumzellen, wie auch für Dünnschicht-Module der aSi-, CdTe- oder CIS-Technologie mit flexiblen Einzelzellen.

Bei Dünnschichtzellen kommt eine Schwierigkeit hinzu, die bisher eine andere Vorgehensweise als die Lamination mit anderen Materialien als Glas und mit anderen Vorrichtungen als konventionellen Flachbett-Laminatoren verhindert hat: Die Verkapselung muss ein sehr gutes Barriereverhalten aufweisen, d. h. hochgradig sperrend gegen Wasserdampf sein. Zugleich muss die Lichtdurchlässigkeit im spektralen Empfindlichkeitsbereich der Solarzelle hoch sein, ein mittlerer Transmissionsgrad von mindestens 90% wird üblicherweise gefordert. Diese Eigenschaften erfüllt zunächst ausschließlich Silikatglas, womit zugleich auch die konventionelle Methode der Lamination für PV-Dünnschichttechnik nahezu zwingend festgelegt scheint.

In jüngster Zeit sind jedoch verschiedene Verfahren der glaslosen Lamination bekannt geworden:
DE 103 56 690 A1 schlägt vor, kristalline Siliziumzellen flexibel und hagelsicher zu verkapseln, indem diese in Vertiefungen einer verformten Kunststoffplatte eingelegt und dort vergossen werden. Dieses Verfahren ist zwar glaslos, jedoch ebenfalls ein batch-Verfahren und relativ zeitaufwändig.

Es sind Spezialmodule auf dem Markt, die statt einer oder zwei Glasplatten als Kapselung eine Platte aus PC (Polycarbonat) verwenden, also nicht flexibel doch glaslos sind. Versuche haben ergeben, dass dieses Plattenmaterial ca. 3 mm dick sein muss, um bei kristallinen Siliziumzellen eine Hagelsicherheit zu gewährleisten; bei PMMA (Acrylglas) und PC (Makrolon) ist die Wasserdampfdurchlässigkeit selbst bei 3 mm Dicke zu hoch, um diese Materialien (ohne zusätzliche Maßnahmen) für Dünnschichtzellen nutzen zu können. Außerdem ist der Laminationsprozess (Einbettung der Zellen "schwimmend" in einer Gel-Schicht) ein ebenso zeitaufwändiger batch-Prozess, wie die konventionelle Verwendung von Silikatglas mit EVA.

Auf dem Markt sind ferner flexible PV-Module mit Triple-aSi-Zellen auf Edelstahlfolie. Statt Glas als Abdeckung wird hier eine Teflonfolie verwendet, der Laminationsprozess als solcher ist jedoch "klassisch". Die Wasserdampfdurchlässigkeit der Teflonfolie liegt im Bereich von wenigen g/m² x Tag, ist somit nicht ausreichend niedrig für die Erfordernisse von Dünnschichtzellen. Daher wird ein zusätzlicher Schutzlack, der in einem Tauchverfahren auf die Oberfläche der Zellen aufgebracht wird, verwendet.

Um in der PV-Modul-Fertigung endlich eine kontinuierliche Durchlauf-Fertigung für Standardmodule zu erhalten, wurden seit einigen Jahren Versuche vorgenommen, einen sogenannten Rollenlaminator (Figur 2) zu entwickeln. Statt der EVA-Folie, die zeitaufwändig aufgeschmolzen wird und erst nach ca. 15 min aushärtet, ist eine Verkapselung der Zellen 3 zwischen einer Frontfolie 4b und Rückseitenfolie 1b mit 2K-Silikonen mittels Anpressrollen 7 vorgesehen. Die Verfahrensentwicklung "Rollenlaminator" wurde letztendlich jedoch wegen ungelöster technologischer Probleme (insbesondere bei Dünnschicht-Zellen) und wegen mangelnder wirtschaftlicher Attraktivität eingestellt.

### Zusammenfassung der Erfindung

Ein oder mehrere der geschilderten Probleme des Standes der Technik werden mit Hilfe des erfindungsgemäßen Verfahrens zur Herstellung eines glaslosen Photovoltaik-Moduls mit einer elektrischen Reihenschaltung mehrerer photovoltaischer Solarzellen, die verkapselt zwischen einer Kunststoffschicht aus einem transparenten, thermoplastischen Kunststoff und einem rückseitigen Trägersubstrat angeordnet sind, gelöst oder zumindest gemindert. Das Verfahren zeichnet sich dadurch aus, dass die Kunststoffschicht durch Extrusion des thermoplastischen Kunststoffs auf einen Rohling des Photovoltaik-Moduls aufgetragen wird.

Ein weiterer Aspekt der Erfindung liegt in der Bereitstellung eines insbesondere über das erfindungsgemäße Verfahren erhältlichen glaslosen Photovoltaik-Moduls mit einer elektrischen Reihenschaltung mehrerer photovoltaischer Solarzellen, die verkapselt zwischen einer Kunststoffschicht aus einem transparenten, thermoplastischen Kunststoff und einem rückseitigen Trägersubstrat angeordnet sind. Das Photovoltaik-Modul ist dadurch gekennzeichnet, dass
(i) die Solarzelle eine Siliziumzelle ist und die Kunststoffschicht direkt auf den Solarzellen aufgebracht ist; oder
(ii) die Solarzelle eine Dünnschichtzelle ist sowie eine ein- oder mehrschichtige, wasserdampf-undurchlässige Barriereschicht direkt auf den Solarzellen und die Kunststoffschicht direkt auf der Barriereschicht aufgetragen ist.

Weitere bevorzugte Ausführungsformen der Erfindung lassen sich den Unteransprüchen oder der weiteren Beschreibung entnehmen.

Das erfindungsgemäße Verfahren unterscheidet 3 Anwendungsfälle:
o Glaslose, nicht flexible Kapselung von kristallinen Siliziumzellen
o Glaslose, nicht flexible Kapselung von Dünnschichtzellen
o Glaslose, flexible Kapselung von Dünnschichtzellen

Das Prinzip, das Solarglas der frontseitigen Abdeckung, verklebt mittels EVA, zu ersetzen durch eine thermoplastische Kunststoffschicht, die direkt aus einer Breitbanddüse des Extruders auf die Solarzellen aufgebracht wird, ist ein Kerngedanke der vorliegenden Erfindung und betrifft alle 3 Anwendungsfälle. In jedem Fall erfolgt unmittelbar nach dem Auftreffen des Kunststoffs ein Aufpressen der plastischen Masse auf die Solarzellen und auf die Unterlage, auf welcher die Solarzellen verschaltet angeordnet und fixiert sind, mittels einer Anpresswalze so, dass eine innige Verbindung zwischen dem plastischen Kunststoff und den Solarzellen bzw. (in den Zellen-Zwischenräumen) zwischen der Verklebung der Zellen mit deren Unterlage hergestellt wird. Zugleich werden Lufteinschlüsse zwischen den Zellen und der Unterlage sowie der abdeckenden plastischen Kunststoffschicht hierdurch vermieden bzw. entgegen der Laufrichtung des Transportbandes der Beschichtung ausgetrieben.

Dicke und Art der extrudierten thermosplastischen Kunststoffschicht unterscheiden sich, je nach Anwendungsfall:
Für kristalline Siliziumzellen findet vorzugsweise PMMA Verwendung, wobei die Schichtdicke wegen der Hagelschlagsicherheit an sich 3 mm betragen muss. Schlagfestigkeit, Transparenz, UV-Beständigkeit und ein günstiger Preis bestimmen die Materialauswahl, während an die Wasserdampfdurchlässigkeit (WVTR; water vapor transmission rate) keine hohen Ansprüche zu stellen sind.

Für die nicht-flexible Lamination von Dünnschichtzellen findet vorzugsweise ebenfalls PMMA mit ca. 3 mm Schichtdicke Verwendung, wobei aber dem Kunststoff Stoffe zugefügt sind, die eine Verminderung der WVTR bewirken, beispielsweise Additive aus sphärischen Siliziumdioxid-Nanopartikeln. Eine vorzugsweise zusätzlich vorhandene Barriereschicht, die eine Speerschicht und optional noch eine Haftschicht beinhaltet, verbessert die WVTR weiter.

Andererseits entsteht, verzichtet man auf Flexibilität, bei 2-3 mm Dicke der thermoplastischen Kunststoffschicht, allein schon durch die gegenüber 200 µm Folie als Deckschicht mindestens 10-fach höhere Materialstärke, eine entsprechend erhöhte Barrierewirkung.

Für die tatsächlich erzielte Sperrwirkung spielen neben Materialeigenschaften auch strukturelle Gegebenheiten, z. B. Freiheit von Dünnstellen, Rissen und pinholes, eine mindestens eben so große Rolle. Die Sperrschicht und Haftschicht werden daher vorzugsweise mehrlagig (multilayer) aufgebracht.

Soweit erforderlich, wird die Barrierewirkung der kompletten Verkapselung noch verstärkt, indem zwischen den Sperrlack und die thermoplastische Kunststoffschicht eine Haftschicht eingebaut wird, die neben der Haftvermittlung eine zusätzliche Sperrwirkung aufweist.

Wenn die Lamination von Dünnschicht-Zellen zugleich flexibel sein soll, so muss die durch extrusion coating aufgebrachte Deckschicht weniger als 1 mm (beispielsweise 200µm) dick sein. Hierfür kommen thermoplastische Kunststoffe in Betracht, die eine geringere WVTR als Metacrylat aufweisen, beispielsweise Polyethylen. Hierbei sind Varianten verfügbar (HDPE, high density PE), welchen in der Literatur eine exzellente Barrierewirkung zugeschrieben wird. Problematisch bei HDPE ist allerdings die Transparenz, optisch klar sind üblicherweise nur die LD-Varianten (low density) von PE. Gegebenenfalls kann daher eine Modifikation von HDPE gewählt werden, bei welcher WVTR (water vapor transmission rate), optische Transmission und Preis gegeneinander abgeglichen sind.

Ähnlich liegen die Verhältnisse bei extrudiertem PP (Polypropylen); dem Material wird eine sehr gute Barrierewirkung bescheinigt, wobei die Transparenz im sichtbaren Spektralbereich 90% erreicht. Auch hier ist für die erfindungsgemäße Nutzung des Materials für das extrusion coating von Solarzellen hinsichtlich WVTR, Schichtdicke, Transparenz und Preis ein Kompromiss erforderlich.

Ein weiteres Material, das bevorzugt für die Realisierung der Erfindung Verwendung finden kann, ist PVdC (Polyvinylidenchlorid) als Methyl-acrylat Copolymer. Dieses hoch transparente Thermoplast hat als Material bereits sehr gute Sperreigenschaften, nach Verarbeitung zur Folie (Krehalon) werden 1,1 g/m² x d bei 200µm Dicke angegeben. Dieser Wert lässt sich mit entsprechenden Additiven, z. B. aus Siliziumdioxid-Nanopartikeln, die sphärisch und/oder mit Polysiloxan bzw. DDS (Dimethyl-dichlorsilan) vorbehandelt sein können, noch weiter verbessern.

Bei der Beurteilung der Sperrwirkung der thermoplastischen Deckschicht (mit oder ohne Additive) ist zu bedenken, dass zusätzlich zu der Deckschicht ein Sperrlack auf den Zellen und darauf ein sperrender Haftlack Verwendung finden kann, so dass die Barrierewirkung von 3 Schichten gemeinsam erbracht wird.

Bei Dünnschicht-Solarzellen in flexibler Kapselung sind derartige zusätzliche Maßnahmen (Additive, Haftschicht, Sperrschicht) unumgänglich, da die thermoplastische Deckschicht nur wenige 100µm dick ist.

Als Sperrschicht können Lacke dienen, vorzugsweise ein praxisbewährter Anti-Grafitti-Lack auf Polysilazan-Basis, wobei die üblichen Auftragsverfahren (Rakeln, Sprühen, Rollen etc.) Anwendung finden.

Vorteilhaft ist, dass nicht die einzelne Zelle, sondern die fertige, mit ihrem Untergrund verklebte Zellenverschaltung die Beschichtung mit Anti-Graffiti-Lack erhalten kann, damit Risse und andere Schäden in der Lackschicht, die bei der Weiterverarbeitung von beschichteten flexiblen Einzelzellen auftreten könnten, vermieden werden. Dabei darf die Viskosität des Sperrlacks nicht zu niedrig eingestellt sein, damit Dünnstellen der sperrenden Lackschicht an den Zellenkanten vermieden werden.

Grundsätzlich sind an den Sperrlack folgende Anforderungen zu stellen: beste Barriereeigenschaften insbesondere hinsichtlich Wasserdampf, hohe Transparenz, hohe UV-Stabilität, und gute Haftung auf der Zellen-Oberfläche wie auch zur nächstfolgenden Schicht. Als Material für die Sperrschicht sind besonders bevorzugt:
(a) ORMOCER (organic modified ceramics)-Lacke. Die Verwendung von Hybridpolymeren auf Basis von Al₂O₃ oder SiO₂ als Sperrschicht für Solarzellen ist allerdings auch anderwärts schon vorgeschlagen worden (DE 10 2006 016 280 A1), jedoch nicht in Verbindung mit extrudierten Deckschichten.
(b) Analog verwendbar als Sperrlack sind auch Precursoren für PDC (polymer derived ceramics)
(c) Ein Lack mit hervorragender Sperrwirkung ist der als Anti-Grafitti-Beschichtung verwendete tutoProm -Lack bzw. Lacke auf gleicher Basis (Polysilazan). Soweit Haftungsschwierigkeiten bei der nachfolgenden Extruder-Beschichtung auftreten, können diese vermieden werden, indem die Extruder-Beschichtung stattfindet, bevor der Anti-Grafitti-Sperrlack voll ausgehärtet ist. TutoProm reagiert mit Feuchtigkeit, was in dem nachfolgend beschriebenen Sinn vorteilhaft sein kann.
(d) Für die Sperrschicht kann ferner STP-U (silanterminiertes Polyurethan) verwendet werden. Feuchtigkeitsaushärtende Lacksysteme können von Vorteil sein, da sie dem Schichtenaufbau Reste von Wasserdampf entziehen, die andernfalls eingeschlossen werden und nachfolgend der Solarzelle schaden könnten.
(e) Auch Lacke auf PVdC-Basis sind als Sperrschicht geeignet, insbesondere nach Beimengung von Silan.

Die Sperrwirkung der Sperrschicht lässt sich ferner weiter erhöhen, indem der Lack mindestens ein organofunktionelles Silan, z. B. Alpha-Methacryloxysilan oder Vinylmethoxysilan in hoher Dosierung enthält.

Zusätzlich oder statt der Silan-Zufügung kann der WVTR-Wert der Sperrschicht auch verbessert werden durch die Beimengung von Silica, Aluminiumoxid oder seltenen Erden, vorzugsweise als Nano-Partikel. Insbesondere die Beimengung seltener Erden zu den Barriereschichten einer Lamination zwecks Erzeugung einer Dampfsperre ist bevorzugt.

Eine deutliche Verbesserung der Barrierewirkung der Sperrschicht wird ferner erzielt, indem diese in mehreren Schichten aufgetragen wird, beispielsweise 3 mal 10 µm statt einer Schicht von 30 µm. Jede Schicht enthält mehr oder weniger viele "pinholes", welche die Barrierewirkung beeinträchtigen; bei einem Mehrschichtsystem wird diese Problematik weitgehend vermieden. Wenn nun aber ohnehin mehrere Lagen (mit jeweils nachfolgender vollständiger oder teilweiser Aushärtung) aufgetragen werden, können ohne zusätzlichen Aufwand auch verschiedene Sperr-Lacke bzw. ein Sperrlack mit verschiedenen Additiven bzw. Beimengungen Verwendung finden.

Die Empfindlichkeit von Dünnschichtzellen verschiedener Technologie gegenüber eindringender Feuchtigkeit ist unterschiedlich groß. Die vorliegende Erfindung vermag den außergewöhnlich hohen Anforderungen an die Sperrwirkung insbesondere dadurch gerecht zu werden, dass zusätzlich zu der sperrenden aufextrudierten Kunststoffschicht und der Sperrschicht noch eine weitere Schicht in die Lamination eingefügt wird. Sie wird nachfolgend als Haftschicht bezeichnet, deren Funktion eine Haftvermittlung zwischen der anorganischen Sperrschicht und der polymeren Kunststoffschicht ist, die aber zugleich auch eine weitere Barriere darstellt. Bewährt haben sich für eine vergleichbare Aufgabenstellung in anderem Zusammenhang anorganische Haftschichten aus Kieselsäure (oder Aluminium- bzw. Mischoxid), die durch eine Behandlung mit Silanen oder Siloxanen hydrophobiert sind.

Unabhängig davon, ob es sich um kristalline Silizium- oder Dünnschichtzellen handelt, muss eine Verklebung der Zellen mit der Unterseite/Rückseite des Laminats erfolgen. Es wird vorgeschlagen, diese Verklebung bei kristallinen Siliziumzellen mit einem nichtdauerelastischen Kleber, beispielsweise mit Epoxydharz-Kleber auszuführen, während bei Dünnschichtzellen ein Kleber auf Basis organofunktioneller Silane Verwendung finden sollte.

Bei Dünnschicht-Zellen, die bereits mit einer Sperrschicht beschichtet sind, ist die LaminatHerstellung produktionstechnisch vorteilhaft möglich, indem zunächst die Modulrückseite mit demselben Lack, wie er für die Haftschicht verwendet wird, beschichtet wird. In diese Schicht werden, solange der Lack noch feucht/fließfähig ist, die Sperrlack-beschichteten Solarzellen eingelegt und unmittelbar folgend die Haftschicht aus demselben Lack aufgebracht. Erst dann erfolgt die Aushärtung, vorzugsweise durch Wärme.

Bei der Verkapselung von kristallinen Siliziumzellen wird die Verklebung der Zellen mit der Modulrückseite einfach ausgeführt, indem der Epoxydkleber die Zellen lediglich einbettet, nicht aber vorderseitig abdeckt. Bei dieser Vorgehensweise ist darauf zu achten, dass der Kleber nicht dauerelastisch ist und dass seine Viskosität so eingestellt ist, dass er die Ecken zwischen der Solarzelle und ihrer Unterlage ausfüllt. Ein "weicher" Klebstoff (beispielsweise Silikon) würde als Untergrund der kristallinen Siliziumzellen die Hagelsicherheit negativ beeinflussen, während nicht mit Klebstoff gefüllte Ecken Gefahr laufen, beim extrusion coating von dem aufgewalzten Thermoplast nicht ganz verfüllt zu werden, was zu unerwünschten Lufteinschlüssen führt.

Eine verbesserte Haftung der thermoplastischen Deckschicht, die durch den Extruder auf den Solarzellen aufgebracht wird, kann erreicht werden, indem die Zellenverklebung vor dem Auftreffen des Kunststoffes auf etwa dieselbe Temperatur, wie das schmelzflüssige Thermoplast beim Auftreffen auf die Zelle erwärmt wird. Mit anderen Worten, der Rohling wird unmittelbar vor dem Auftreffen des thermosplastischen Kunststoffes aus dem Extruder auf eine Temperatur nahe der Temperatur des auftreffenden, schmelzflüssigen Kunststoffs gebracht. Das Thermoplast sollte in der Regel eine Temperatur von nicht mehr als 150°C haben, wenn es auf die Zelle trifft.

Bereits beschrieben wurde, dass unmittelbar nach dem Aufbringen der frontseitigen Kunststoffschicht, in kurzem Abstand hinter der Breitbanddüse des Extruders, die plastische Masse mittels Walzen auf die Solarzellen gepresst wird. Zugleich oder in einem nachfolgenden Schritt erhält die Oberfläche des Laminats mittels (gekühlter) Walzen eine prismatische Struktur. Die Kanten der Prismen sind hierbei gerundet; letzteres begünstigt das Ablaufen von Wasser und Schmutz, während die prismatische Strukturierung selbst mehrere Vorteile mit sich bringt:
o zunächst wird durch den punktförmigen Anpressdruck die innige Verbindung zwischen der Deckschicht und der Solarzellen-Verklebung gefördert.
o Kleine Unregelmäßigkeiten der Modul-Oberfläche werden überdeckt, der Modul somit unempfindlicher gemacht gegen kleine Beschädigungen bei Transport und Montage.
o Schließlich führt die prismatische Prägung dazu, dass ein höherer Strahlungsanteil die Zellen erreicht: eine Prismenstruktur von ca. 2 mm Prismenabstand und 1 mm Prismenhöhe führt zu einer Steigerung der PV-Leistung bei senkrechtem Lichteinfall von ca. 3 %, bei schräger Einstrahlung von bis zu 20 %.

Das Aufwalzen einer prismatischen Struktur stellt somit in mehrfacher Hinsicht eine Verbesserung des Erfindungsgedankens dar.

Eine weitere Verbesserung von glaslosen PV-Modulen, die durch extrusion coating hergestellt wurden, stellt eine vorderseitige Beschichtung mit einem sogenannten "easy-toclean" coating dar. Hiermit werden zugleich mehrere Vorteile erzielt, welche das Laminat einem Silikatglas-verkapselten Modul ähnlicher machen
o Schutz gegen Verschmutzung
o erhöhte Kratzfestigkeit
o zusätzliche Sperrwirkung gegen Eindringen von Feuchtigkeit
o erhöhte UV-Beständigkeit

Entsprechende Beschichtungen, die die genannten Eigenschaften aufweisen, sind am Markt erhältlich; ihr Anwendungsbereich war bisher jedoch nicht die Oberfläche von PV-Modulen, weil es hierzu wegen der üblichen Verwendung von Silikatglas keine Veranlassung gab.

### Zeichnungen

Die Erfindung wird nachfolgend anhand von Zeichnungen und Ausführungsbeispielen näher erläutert. Es zeigen:
- Fig. 1: eine schematische Schnittansicht durch ein herkömmliches PV-Modul
- Fig. 2: eine schematische Darstellung einer herkömmlichen Variante zur Herstellung eines PV-Moduls
- Fig. 3: eine schematische Darstellung der erfindungsgemäßen Herstellung eines PV-Moduls
- Fig. 4: eine schematische Schnittansicht durch ein erfindungsgemäßes PV-Modul mit Siliziumzellen
- Fig. 5: eine schematische Schnittansicht durch ein erfindungsgemäßes PV-Modul mit Dünnschichtzellen

### Ausführliche Beschreibung der Erfindung

### Ausführungsbeispiel 1

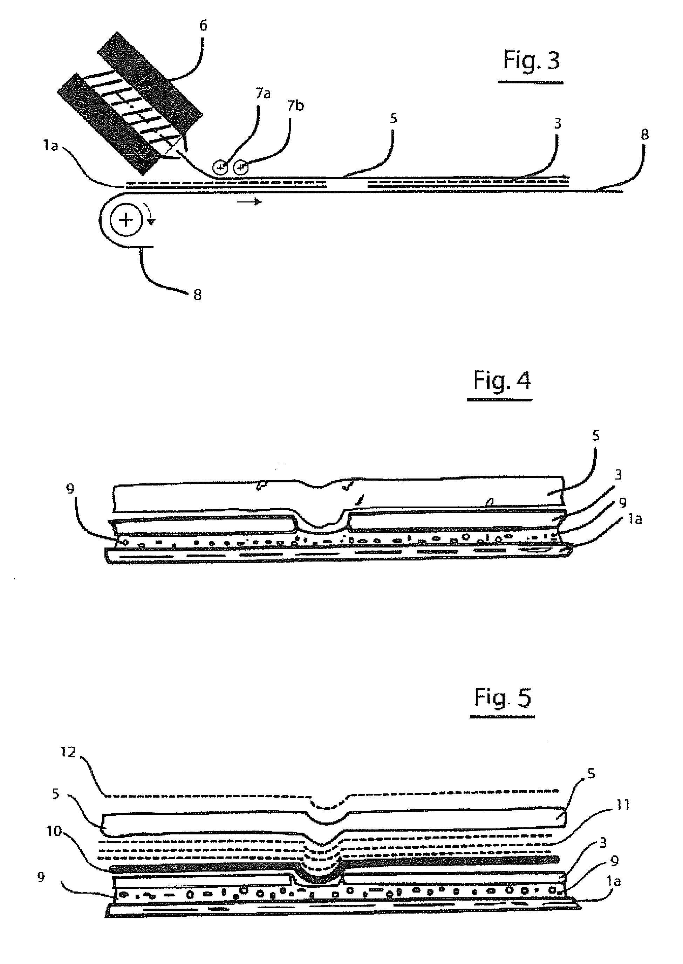

Das erste Ausführungsbeispiel betrifft eine glaslose, nicht flexible Kapselung von kristallinen Siliziumzellen 3 (Figur 4). Als Rückseite 1 wurde ein 2 mm dickes Alublech, in federharter Qualität gewählt, die Verklebung (Schicht 9) der cSi-Zellen 3 erfolgte mit handelsüblichem Epoxy-Kleber, weil Epoxy, im Gegensatz zu Silikon-Klebstoffen, den erwünschten harten Untergrund der kristallinen Zellen bildet.

Zur Beschichtung mit einer Kunststoffschicht 5 werden die einzelnen Rohlinge auf ein Transportband 8 gelegt (Figur 3). Über einer Extruder 6 wird das Kunststoffmaterial zugeführt und mit den Walzen 7a, 7b angepresst und gegebenenfalls gekühlt.

Die Extruder-Beschichtung erfolgte mit PMMA, mit einem Additiv von 20% Silica (mit Polysiloxan oberflächenbehandelt) in Methoxypropylacetat / Methoxypropanol, Eine Sperr-oder Haftschicht oder vorderseitige "easy to clean"-Beschichtung wurde nicht verwendet, 2 mm Dicke der extrudierten Acrylschicht erwiesen sich bei diesem Aufbau (wegen der verwendeten Additive und dem harten Zellen-Untergrund) hinsichtlich Hagelsicherheit als ausreichend.

### Ausführungsbeispiel 2

Das zweite Ausführungsbeispiel (ohne eigene Abbildung, im Aufbau ähnlich wie Fig. 4) betrifft eine glaslose, nicht flexible Kapselung von CISS-Dünnschicht-Zellen (Zellen mit Polyimid-Foliensubtrat).

Als Rückseite wurde ein 0,6 mm dickes veredeltes Stahlblech gewählt, welches feuchtigkeitsundurchlässig ist, eine gute Verklebbarkeit zeigt sowie einen geringen thermischen Ausdehnungskoeffizient und sehr gute Korrosionsbeständigkeit besitzt.

Zur Verklebung der Zellen mit der Laminat-Rückseite wird ein Klebstoff auf Basis organofunktioneller Silane verwendet, welcher eine Brücke bildet zwischen anorganischen Materialien und organischen Polymeren und zugleich als "Wasserfänger" dient. Die nur ca. 10 µm dicke Sperrschicht auf der Zellen-Oberfläche besteht aus einem farblosen 2K-Klarlack auf Basis modifizierter Polysilazane. Diese Sperrschicht wird als multilayer in 3 Arbeitsgängen mit je ca. 3 µm Dicke aufgebracht. Als frontseitige, durch das erfindungsgemäße "extrusion coating" aufgebrachte Deckschicht wird ebenso wie in Beispiel 1 eine 2 mm dicke PMMA-Schicht mit sperrenden und oberflächen-verbessernden Eigenschaften, die durch Additive erreicht werden, verwendet.

### Ausführungsbeispiel 3

Das dritte Ausführungsbeispiel betrifft eine glaslose und flexible Kapselung von CISS-Dünnschicht-Zellen (z. B. Zellen auf 25 µm Edelstahl-Substrat). Figur 5 zeigt eine Schnittansicht durch ein solches PV-Modul.

Als Rückseite 1 findet eine Verbundfolie, wie sie von konventionellen Laminationen her bekannt ist, Verwendung. Die Verklebung (Schicht 9) der Zellen 3 mit der Rückseite 1 entspricht Beispiel 1 und 2. Eine Sperrschicht 10 wird durch Aufsprühen von Anti-Grafitti-Lack realisiert, wiederum in mehreren Arbeitsgängen (Multilayer). Als Haftschicht 11 wird wiederum ein Haftlack auf Basis organofunktioneller Silane verwendet, welcher eine Brücke bildet zwischen anorganischen Materialien und organischen Polymeren und zugleich als "Wasserfänger" dient, unter Beimengung von Ceroxyd-Nanopowder zwecks weiterer Verminderung der Wasserdampf-Permeabilität. Nachfolgend wird im Extruder eine 0,2 mm dicke Kunststoffschicht 5 aus PVdC aufgebracht, deren Wasserdampf-Durchlässigkeit von 0,25 g/m² x d (Zahlenwert aus der Literatur) mit einem Additiv analog der Beimengung im PMMA bei Beispiel 1 und 2 verbessert wurde.

Abschließend erfolgt eine Oberflächenvergütung durch Auftragung einer Schutzbeschichtung 12 des fertigen Laminats, die zugleich eine zusätzliche Sperrschicht darstellt, mit hochtransparentem, niedrig viskosen, Silica-Nanopartikel enthaltendem "Sperrlack" auf Acryl-Basis.

Durch das erfindungsgemäße Vorgehen entstehen eine ganze Reihe von Vorteilen:
Die Kapselung von Solarzellen per "extrusion coating" ist ein kontinuierliches Verfahren mit hoher Produktionsgeschwindigkeit, im Gegensatz zum derzeit üblichen, langsamen batch-Verfahren der Flachbett-Lamination.

Einsparungen an Materialkosten sind zwangsläufig, da das Ausgangsmaterial KunststoffGranulat ist, anstelle von Kunststoff-Folien; die Verwendung von Schmelzklebefolie (z. B. EVA) entfällt, weil der Kunststoff in schmelzflüssigem Zustand auf die Solarzellen aufgebracht wird.

Die Verwendung von Granulat beim erfindungsgemäßen "extrusion coating" erlaubt die Zufügung von Additiven zur gezielten Modifikation der Eigenschaften der Deckschicht, z. B. zur Verbesserung der Barriere-Wirkung.

Die Verwendung von Kunststoff statt Glas als Deckschicht hat Bruchsicherheit und ein deutlich geringeres Gewicht der Module zur Folge.

Da die Wärmeleitfähigkeit von Kunststoff nur ein Bruchteil der Wärmeleitung von Glas beträgt, können PVT-Module hiermit besonders vorteilhaft hergestellt werden: Die mit einer frontseitigen Kunststoff-Abdeckung von 2-3mm "geernteten" Wassertemperaturen liegen nämlich deutlich über den Temperaturwerten von PVT-Kollektoren (Hybrid-Modul mit PV und Thermie) mit Glasabdeckung, wodurch in den Sommermonaten der Einsatz einer Wärmepumpe zur Brauchwasser-Erwärmung überflüssig wird.

Flexible Dünnschicht-Zellen mit problematischem Degradationsverhalten werden kostengünstig alterungsbeständig gekapselt. Die Erfindung nennt eine Fülle von Maßnahmen zur Erreichung einer hohen Barrierewirkung, wobei durch Kombination dieser Maßnahmen die Sperrwirkung gegen Eindringen von Feuchtigkeit nahezu beliebig hoch getrieben werden kann.

## Patentansprüche

1. Verfahren zur Herstellung eines glaslosen Photovoltaik-Moduls mit einer elektrischen Reihenschaltung mehrerer photovoltaischer Solarzellen (3), die verkapselt zwischen einer Kunststoffschicht (5) aus einem transparenten, thermoplastischen Kunststoff und einem rückseitigen Trägersubstrat (1) angeordnet sind, **dadurch gekennzeichnet, dass** die Kunststoffschicht (5) durch Extrusion des thermoplastischen Kunststoffs auf einen Rohling des Photovoltaik-Moduls aufgetragen wird.

2. Verfahren nach Anspruch 1, bei dem der thermoplastische Kunststoff ohne Verwendung eines zwischengefügten Schmelzklebers aus einem Extruder (6) aufgebracht wird.

3. Verfahren nach Anspruch 2, bei dem der Rohling unmittelbar vor dem Auftreffen des thermosplastischen Kunststoffes aus dem Extruder (6) auf eine Temperatur nahe der Temperatur des auftreffenden, schmelzflüssigen Kunststoffs gebracht wird.

4. Verfahren nach einem der vorhergehenden Ansprüche, bei dem die Kunststoffschicht (5) unmittelbar nach ihrem Auftrag auf den Rohling durch Walzen (7a, 7b) angepresst und auf seiner Oberfläche prismatisch strukturiert wird.

5. Glasloses Photovoltaik-Modul mit einer elektrischen Reihenschaltung mehrerer photovoltaischer Solarzellen (3), die verkapselt zwischen einer Kunststoffschicht (5) aus einem transparenten, thermoplastischen Kunststoff und einem rückseitigen Trägersubstrat (1) angeordnet sind, **dadurch gekennzeichnet, dass**
(i) die Solarzelle (3) eine Siliziumzelle ist und die Kunststoffschicht (5) direkt auf den Solarzellen (3) aufgebracht ist; oder
(ii) die Solarzelle (3) eine Dünnschichtzelle ist sowie eine ein- oder mehrschichtige, wasserdampf-undurchlässige Barriereschicht direkt auf den Solarzellen (3) und die Kunststoffschicht (5) direkt auf der Barriereschicht aufgetragen ist.

6. Glasloses Photovoltaik-Modul nach Anspruch 5, bei dem der Kunststoff für die Kunststoffschicht (5) ausgewählt ist aus Polymethylmethacrylat (PMMA), Vinylidenchlorid-Methylacrylat-Copolymer (MA-PVDC), High Density Polyethylen (HDPE) oder hoch transparentem Polypropylen (PP).

7. Glasloses Photovoltaik-Modul nach Anspruch 5 oder 6, bei dem die Kunststoffschicht (5) als Additiv Nanopartikel aus Oxiden des Siliziums, Aluminiums oder von Seltenerden enthält.

8. Glasloses Photovoltaik-Modul nach Variante (ii) des Anspruchs 5, bei dem die Barriereschicht eine ein- oder mehrlagige Sperrschicht (10) aus einem Material ausgewählt aus einem Ormocer, einem Lack auf Polysilazan-Basis oder einem silanterminierten Polyurethan (STP-U) umfasst.

9. Glasloses Photovoltaik-Modul nach Anspruch 8, bei dem die Speerschicht (10) als Additiv Nanopartikel aus Oxiden des Siliziums, Aluminiums oder von Seltenerden enthält.

10. Glasloses Photovoltaik-Modul nach Variante (ii) des Anspruchs 5, bei dem die Barriereschicht eine ein- oder mehrlagige Sperrschicht (10) und einen auf der Speerschicht (10) aufgebrachten Haftlack (11) umfasst.

11. Glasloses Photovoltaik-Modul nach Anspruch 10, bei dem der Haftlack (11) eine Kieselsäure oder Aluminiumoxid enthält, die/das durch Behandlung mit Silanen oder Siloxanen hydrophobiert ist.

12. Glasloses Photovoltaik-Modul nach Variante (ii) des Anspruchs 5, bei dem eine Schutzbeschichtung (12) direkt auf der Kunststoffschicht (5) aufgebracht ist.
